# EUROPÄISCHE PATENTANMELDUNG

(11) **EP 4 711 351 A1**
(43) Veröffentlichungstag der Anmeldung: **18.03.2026**
(21) Anmeldenummer: 24203861.0
(22) Anmeldetag: 01.10.2024
(51) Int. Cl.: C04B 37/02

(54) **VERFAHREN ZUR HERSTELLUNG VON METALL-KERAMIK-SUBSTRATEN UND METALL-KERAMIK-SUBSTRAT**

(30) Priorität: 12.09.2024 US 202463693904 P
(71) Anmelder: Heraeus Electronics GmbH & Co. KG, 63450 Hanau (DE); Heraeus Precious Metals North America Conshohocken LLC, West Conshohocken, PA 19428 (US)
(72) Erfinder: Fabian, Benjamin, 63450 Hanau (DE); Fritzsche, Sebastian, 63450 Hanau (DE); Müller, Marco, 63450 Hanau (DE); Koser, Felix Alexander, 63450 Hanau (DE); Mustain, Habib A., West Conshohocken, 19428 (US)
(74) Vertreter: Heraeus IP

(57) **Zusammenfassung**

Die Erfindung betrifft ein Verfahren zur Herstellung von Metall-Keramik-Substraten. Das Verfahren umfasst die Schritte: (a) Bereitstellen eines Mehrfachsubstrats, das eine Mehrzahl von Metall-Keramik-Substraten umfasst, wobei (i) die Metall-Keramik-Substrate jeweils (I) einen Keramikkörper und (II) wenigstens eine Metallschicht, die flächig mit dem Keramikkörper verbunden ist, umfassen, und (ii) das Mehrfachsubstrat einen Keramikgrundkörper aufweist, der die Keramikkörper der Metall-Keramik-Substrate umfasst, wobei der Keramikgrundkörper Sollbruchlinien aufweist, (b) Durchtrennen des Mehrfachsubstrats entlang der Sollbruchlinien des Keramikgrundkörpers unter Vereinzelung der Metall-Keramik-Substrate, und (c) Auslagerung von vereinzelten Metall-Keramik-Substraten bei einer Temperatur von 110 - 250°C und für einen Zeitraum im Bereich von 1 s - 25 min. erfolgt, wobei die Auslagerung vor der Bestückung der Metall-Keramik-Substrate mit Bauteilen erfolgt.

## Beschreibung

Die vorliegende Erfindung betrifft ein Verfahren zur Herstellung von Metall-Keramik-Substraten und ein Metall-Keramik-Substrat.

Metall-Keramik-Substrate spielen eine wichtige Rolle im Bereich der Leistungselektronik. Sie sind ein maßgebliches Element beim Aufbau von elektronischen Baugruppen und sorgen für eine schnelle Ableitung hoher Wärmemengen beim Betrieb dieser Baugruppen. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Metallfolien bei Temperaturen von etwa 650 bis 1000°C mit Keramikkörpern verbunden werden, wobei ein spezielles Lot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Alternativ dazu können auch silberfreie Lote zur Verbindung von Metallfolien mit Keramikkörpern zum Einsatz kommen. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Metall-Keramik-Substrate werden überwiegend im Mehrfachnutzen hergestellt. Dabei wird eine Mehrzahl an Metall-Keramik-Substraten in einem Mehrfachsubstrat aufgebaut, indem ein - relativ großflächiger - Keramikgrundkörper auf wenigstens einer Oberflächenseite mit einer Metallfolie flächig stoffschlüssig verbunden wird. Die Metallfolie wird anschließend durch geeignete Techniken, wie zum Beispiel Ätzen, teilweise wieder entfernt, um Strukturierungen vorzusehen und die Metallfolie in voneinander isolierte Bereiche zu trennen. Ferner werden in dem nun freigelegten Keramikgrundkörper zwischen den voneinander isolierten Bereichen der Metallfolie Sollbruchlinien geschaffen. Durch Durchtrennen (zum Beispiel Brechen oder Schneiden) entlang der Sollbruchlinien können schließlich die einzelnen Metall-Keramik-Substrate aus dem Mehrfachnutzen erhalten werden. Diese Technik ist dem Fachmann bekannt und zum Beispiel in der DE 4319944 A1 und der EP 1061783 B1 beschrieben.

Bei der Herstellung von Metall-Keramik-Substraten im Mehrfachnutzen treten häufig Probleme mit der Durchbiegung der Metall-Keramik-Substrate auf. So sind bereits die als Ausgangsmaterial eingesetzten Keramikgrundkörper selten planar, sondern üblicherweise gebogen. Diese Durchbiegung wird auch als ("Warpage") bezeichnet. Die Durchbiegung ist an unterschiedlichen Stellen desselben Keramikgrundkörpers unterschiedlich ausgeprägt, so dass lokal unterschiedliche Durchbiegungsmuster vorliegen. Mithin liegt zum Beispiel an einer Stelle des Keramikgrundkörpers eine konvexe Durchbiegung vor, während an einer anderen Stelle eine konkave Durchbiegung vorliegt. Die lokal unterschiedlichen Durchbiegungsmuster liegen nicht nur im Keramikgrundkörper vor, sondern auch in dem ausgehend von dem Keramikgrundkörper hergestellten Mehrfachsubstrat. Folglich weisen Metall-Keramik-Substrate, die aus einem Mehrfachsubstrat herausgelöst werden, unterschiedliche Durchbiegungsmuster auf. Diese unterschiedlichen Durchbiegungsmuster erweisen sich in der nachfolgenden Fertigungsstufe als Problem, da sich Metall-Keramik-Substrate, die unterschiedliche Durchbiegungsmuster aufweisen, nicht einheitlich in der Massenfertigung mit Bauteilen (zum Beispiel Halbleiterbauteilen) in der erforderlichen Qualität, insbesondere im Hinblick auf die Festigkeit der Anbindung und die Temperaturwechselbeständigkeit der geschaffenen Verbindung, bestücken lassen, so dass regelmäßig Ausbeuteverluste auftreten.

Der Erfindung liegt daher die Aufgabe zugrunde, ein Verfahren zur Herstellung von Metall-Keramik-Substraten bereitzustellen, bei dem eine Mehrzahl an Metall-Keramik-Substraten, die aus einem Mehrfachsubstrat erhalten werden, ein einheitliches Durchbiegungsmuster aufweisen.

Diese Aufgabe wird gelöst durch das Verfahren von Anspruch 1.

Die Erfindung stellt daher ein Verfahren zur Herstellung von Metall-Keramik-Substraten bereit, umfassend die Schritte:
(a) Bereitstellen eines Mehrfachsubstrats, das eine Mehrzahl von Metall-Keramik-Substraten umfasst, wobei
   (i) die Metall-Keramik-Substrate jeweils
      (I) einen Keramikkörper und
      (II) wenigstens eine Metallschicht, die flächig mit dem Keramikkörper verbunden ist, umfassen, und
   (ii) das Mehrfachsubstrat einen Keramikgrundkörper aufweist, der die Keramikkörper der Metall-Keramik-Substrate umfasst, wobei der Keramikgrundkörper Sollbruchlinien aufweist,
(b) Durchtrennen des Mehrfachsubstrat entlang der Sollbruchlinien des Keramikgrundkörpers unter Vereinzelung der Metall-Keramik-Substrate, und
(c) Auslagerung von vereinzelten Metall-Keramik-Substraten bei einer Temperatur von wenigstens 110°C.

Die Erfindung betrifft ferner ein Metall-Keramik-Substrat.

Bei dem Verfahren wird in Schritt (a) ein Mehrfachsubstrat bereitgestellt, das eine Mehrzahl von Metall-Keramik-Substraten umfasst.

Das Mehrfachsubstrat kann je nach Ausgestaltung eine unterschiedliche Anzahl von Metall-Keramik-Substraten aufweisen. Vorzugsweise weist das Mehrfachsubstrat wenigstens 2, mehr bevorzugt wenigstens 5, noch mehr bevorzugt wenigstens 100, besonders bevorzugt wenigstens 30 und ganz besonders bevorzugt wenigstens 50 Metall-Keramik-Substrate auf. Das Mehrfachsubstrat weist vorzugsweise weniger als 500, mehr bevorzugt weniger als 250, noch mehr bevorzugt weniger als 200, besonders bevorzugt weniger als 150 und ganz besonders bevorzugt weniger als 100 Metall-Keramik-Substrate auf. Daher weist das Mehrfachsubstrat vorzugsweise 2 - 500, mehr bevorzugt 5 - 250, noch mehr bevorzugt 10 - 200, besonders bevorzugt 30 - 150 und ganz besonders bevorzugt 50 - 100 Metall-Keramik-Substrate auf.

In dem Mehrfachsubstrat sind alle Metall-Keramik-Substrate vorzugsweise durch den gemeinsamen Keramikgrundkörper miteinander verbunden. Die Verbindung der Metall-Keramik-Substrate wird in dem Verfahren zu einem späteren Zeitpunkt durch ein Durchtrennen entlang von Sollbruchlinien des Keramikgrundkörpers aufgehoben.

Die Metall-Keramik-Substrate umfassen jeweils einen Keramikkörper.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist vorzugsweise Begrenzungsflächen auf, im Falle eines Quaders sechs Begrenzungsflächen. Als Hauptbegrenzungsfläche wird hierin vorzugsweise die Begrenzungsfläche (ganz besonders bevorzugt die Begrenzungsfläche mit dem größten Flächeninhalt) bezeichnet, die mit der Metallschicht flächig verbunden ist. Die Hauptbegrenzungsfläche liegt vorzugsweise in der Haupterstreckungsebene des Keramikkörpers oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siliziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen. Gemäß noch einer weiteren ganz besonders bevorzugten Ausführungsform ist der Keramikkörper frei von Bismut, Gallium und Zink.

Der Keramikkörper ist vorzugsweise beidseitig mit einer Metallschicht verbunden. Dabei ist vorzugsweise die Hauptbegrenzungsfläche des Keramikkörpers mit der Metallschicht flächig verbunden und die der Hauptbegrenzungsfläche abgewandte Fläche des Keramikkörpers mit der Metallschicht flächig verbunden.

Der Keramikkörper weist vorzugsweise eine Dicke im Bereich von 0,05 - 10 mm, mehr bevorzugt eine Dicke im Bereich von 0,1 - 5 mm und besonders bevorzugt eine Dicke im Bereich von 0,15 - 3 mm auf.

Die Metall-Keramik-Substrate umfassen jeweils wenigstens eine Metallschicht, die flächig mit dem Keramikkörper verbunden ist.

Die Metallschicht weist vorzugsweise Begrenzungsflächen auf. Die Metallschicht weist vorzugsweise eine Hauptbegrenzungsfläche auf. Als Hauptbegrenzungsfläche wird hierin vorzugsweise die Begrenzungsfläche (ganz besonders bevorzugt die Begrenzungsfläche mit dem größten Flächeninhalt) bezeichnet, die dem Keramikkörper abgewandt ist. Die Hauptbegrenzungsfläche liegt vorzugsweise in der Haupterstreckungsebene der Metallschicht oder verläuft parallel zu dieser. Demnach wird unter Haupterstreckungsebene der Metallschicht vorzugsweise eine Ebene verstanden, die parallel zur Hauptbegrenzungsfläche der Metallschicht verläuft oder diese umschließt. Die Hauptbegrenzungsfläche der Metallschicht verläuft vorzugsweise parallel zur Hauptbegrenzungsfläche des Keramikkörpers und ist von dieser besonders bevorzugt beabstandet.

Die Metall-Keramik-Substrate umfassen jeweils vorzugsweise eine erste Metallschicht, die flächig mit dem Keramikkörper flächig verbunden ist, und eine zweite Metallschicht, die mit dem Keramikkörper flächig verbunden ist. Die erste Metallschicht und die zweite Metallschicht sind vorzugsweise mit voneinander abgewandten Flächen des Keramikkörpers flächig verbunden. Die Metall-Keramik-Substrate umfassen daher vorzugsweise beidseitig mit dem Keramikkörper flächig verbundene Metallschichten.

Die Metallschicht umfasst vorzugsweise wenigstens ein Metall, das aus der Gruppe ausgewählt, die aus Kupfer, Aluminium und Molybdän besteht. Gemäß einer besonders bevorzugten Ausführungsform umfasst die Metallschicht wenigstens ein Metall, das aus der Gruppe ausgewählt, die aus Kupfer und Aluminium besteht. Gemäß einer ganz besonders bevorzugten Ausführungsform umfasst die Metallschicht Kupfer. Gemäß einer weiteren bevorzugten Ausführungsform besteht die Metallschicht aus Kupfer und unvermeidlichen Verunreinigungen. Gemäß einer weiteren bevorzugten Ausführungsform beträgt der Anteil an Kupfer wenigstens 60 Gewichtsprozent, mehr bevorzugt wenigstens 65 Gewichtsprozent, noch mehr bevorzugt wenigstens 70 Gewichtsprozent und besonders bevorzugt wenigstens 75 Gewichtsprozent, bezogen auf das Gesamtgewicht der Metallschicht (vorzugsweise einschließlich einer gegebenenfalls enthaltenen Verbindungsschicht).

Die Metallschicht ist mit dem Keramikkörper flächig verbunden. Vorzugsweise ist die Metallschicht mit dem Keramikkörper stoffschlüssig verbunden. Gemäß einer bevorzugten Ausführungsform ist die Metallschicht mit dem Keramikkörper flächig durch ein Verfahren verbunden, das aus der Gruppe ausgewählt ist, die aus DCB (Direct Copper Bonded)-Verfahren und Hartlotverfahren, insbesondere AMB (Active Metal Brazing)-Verfahren, besteht. Gemäß einer besonders bevorzugten Ausführungsform ist die Metallschicht mit dem Keramikkörper über ein DCB (Direct Copper Bonding) -Verfahren verbunden. DCB-Verfahren sind dem Fachmann bekannt und zum Beispiel in der US 3744120 A oder der DE 2319854 C2 beschrieben. Gemäß einer weiteren besonders bevorzugten Ausführungsform ist die Metallschicht mit dem Keramikkörper über ein Hartlotverfahren verbunden. Bei dem Hartlotverfahren kann es sich zum Beispiel um ein AMB-Verfahren handeln. Bei dem AMB-Verfahren handelt es sich vorzugsweise um ein Verfahren, bei dem ein Hartlot verwendet wird, das einen Silbergehalt von weniger als 1,0 Gewichtsprozent, bezogen auf den Feststoffgehalt des Hartlots, aufweist. Alternativ handelt es sich bei dem AMB-Verfahren um ein Verfahren, bei dem ein Hartlot verwendet wird, das einen Silbergehalt von wenigstens 50 Gewichtsprozent, bezogen auf den Feststoffgehalt des Hartlots, aufweist. Folglich kann die Metallschicht auch eine Verbindungsschicht umfassen, die mit dem Keramikkörper in Kontakt steht. Bei der Verbindungsschicht kann es sich zum Beispiel um eine Lotschicht (insbesondere eine Hartlotschicht) oder eine Diffusionsschicht handeln. Die Verbindungsschicht weist vorzugsweise weniger als 1,0 Gewichtsprozent Silber, bezogen auf das Gesamtgewicht der Verbindungsschicht, auf.

Gemäß einer bevorzugten Ausführungsform weist die Metallschicht einen Strukturierungsbereich auf. Unter Strukturierungsbereich wird vorzugsweise ein Abschnitt der Metallschicht verstanden, der eine Strukturierung enthält. Bei einer Strukturierung handelt es sich vorzugsweise um eine Ausnehmung in der Metallschicht. Folglich umfasst die Hauptbegrenzungsfläche der Metallschicht vorzugsweise Metall der Metallschicht, das im Strukturierungsbereich von der Ausnehmung unterbrochen ist. Die Strukturierung wird vorzugsweise vorgesehen, um erforderliche Leiterbahnen oder Kontaktflächen zu schaffen.

Gemäß einer weiteren bevorzugten Ausführungsform umfasst die Metallschicht einen Kontaktbereich, der besonders bevorzugt Silber aufweist. Der Kontaktbereich dient vorzugsweise dazu, die Anbindung eines Halbleiterbauteils (zum Beispiel eines Chips) auf der Metallschicht zu erleichtern. Chips werden vorzugsweise durch Sintern, Löten oder Kleben mit der Metallschicht verbunden. Da insbesondere das Befestigen von Chips auf dem Hauptmetall der Metallschicht eines Metall-Keramik-Substrats nicht ohne weiteres möglich ist, umfasst die Metallschicht vorzugsweise einen Kontaktbereich. Der Kontaktbereich besteht vorzugsweise aus Silber oder einer silberhaltigen Legierung. Im Fall einer silberhaltigen Legierung enthält diese wenigstens 50 Gewichtsprozent Silber, bezogen auf das Gewicht der Silberlegierung. Vorzugsweise umfasst die Metallschicht einen Kontaktbereich an allen Positionen, wo später eine Bestückung des Metall-Keramik-Substrats mit Chips erfolgen soll.

Die Metallschicht ist vorzugsweise eine integrale Metallschicht. Die Metallschicht ist im Hinblick auf die stoffliche Zusammensetzung nicht zwingend homogen ausgebildet. Die Metallschicht ist aber vorzugsweise so ausgestaltet, dass alle Anteile der Metallschicht, wie zum Beispiel der Kontaktbereich, ein nicht mehr lösbarer Bestandteil der Metallschicht sind.

Die Metallschicht weist vorzugsweise eine Dicke im Bereich von 0,01 - 10 mm, besonders bevorzugt eine Dicke im Bereich von 0,03 - 5 mm und ganz besonders bevorzugt eine Dicke im Bereich von 0,05 - 3 mm auf.

Das Mehrfachsubstrat weist einen Keramikgrundkörper auf, der die Keramikkörper der Metall-Keramik-Substrate umfasst. Der Keramikgrundkörper ist vorzugsweise einstückig ausgebildet und umfasst eine Mehrzahl an Bereichen, die die Keramikkörper der Metall-Keramik-Substrate bilden. Die Keramikkörper liegen in dem Mehrfachsubstrat daher vorzugsweise nicht vereinzelt vor. Vielmehr sind in dem Mehrfachsubstrat alle Keramikkörper der Metall-Keramik-Substrate vorzugsweise Teil des gemeinsamen Keramikgrundkörpers. Die einzelnen Keramikkörper des Keramikgrundkörpers sind jeweils vorzugsweise flächig mit wenigstens einer Metallschicht verbunden.

Der Keramikgrundkörper weist Sollbruchlinien auf. Dabei ist durch Durchtrennen entlang der Sollbruchlinien des Keramikgrundkörpers eine Vereinzelung der Metall-Keramik-Substrate vorgesehen. Die Sollbruchlinien sind vorzugsweise durch Ausnehmungen im Keramikgrundkörper geschaffen. Vorzugsweise sind die Sollbruchlinien im Keramikgrundkörper so angebracht, dass durch Durchtrennen entlang der Sollbruchlinien (zum Beispiel durch Brechen oder Schneiden) des Keramikgrundkörpers die Verbindungen zwischen den einzelnen Keramikkörpern des Keramikgrundkörpers aufgehoben werden. Dabei werden die Metall-Keramik-Substrate, die die einzelnen Keramikkörper umfassen, vereinzelt.

Das Mehrfachsubstrat wird vorzugsweise durch ein dem Fachmann bekanntes Verfahren hergestellt, wie es beispielsweise in der DE 4319944 A1 oder der EP 1061783 B1 beschrieben ist. Daher wird vorzugsweise ein Keramikgrundkörper bereitgestellt. Der Keramikgrundkörper wird - einseitig oder beidseitig - flächig mit einer Metallfolie verbunden. Die Verbindung des Keramikgrundkörpers mit der Metallfolie erfolgt vorzugsweise über ein DCB (Direct Copper Bonding) -Verfahren oder ein Hartlotverfahren. Bei dem Hartlotverfahren kann es sich zum Beispiel um ein AMB-Verfahren handeln. Bei dem AMB-Verfahren handelt es sich vorzugsweise um ein Verfahren, bei dem ein Hartlot verwendet wird, das einen Silbergehalt von weniger als 1,0 Gewichtsprozent, bezogen auf den Feststoffgehalt des Hartlots, aufweist. Alternativ handelt es sich bei dem AMB-Verfahren um ein Verfahren, bei dem ein Hartlot verwendet wird, das einen Silbergehalt von wenigstens 50 Gewichtsprozent, bezogen auf den Feststoffgehalt des Hartlots, aufweist. In dem so erhaltenen Verbund aus Keramikgrundkörper und Metallfolie wird vorzugsweise die Metallfolie durch fachübliche Techniken, wie zum Beispiel Ätzen, teilweise entfernt, um die Metallfolie in voneinander isolierte Bereiche zu trennen. Die voneinander isolierten Bereiche der Metallfolie stellen vorzugsweise die Metallschichten der Metall-Keramik-Substrate dar. Durch das teilweise Entfernen der Metallfolie werden Bereiche des Keramikgrundkörpers freigelegt. In diesen freigelegten Bereichen des Keramikgrundkörpers werden ebenfalls durch fachübliche Techniken, wie zum Beispiel unter Verwendung eines Lasers oder durch mechanische Verfahren, Sollbruchlinien geschaffen. Ferner kann das Mehrfachsubstrat Strukturierungen aufweisen. Diese Strukturierungen werden vorzugsweise durch Ausnehmungen in der Metallschicht gebildet. Die Strukturierungen können in die Metallfolie oder die Metallschicht eingebracht werden. Vorzugsweise werden die Strukturierungen durch fachübliche Techniken, wie zum Beispiel Ätzen, geschaffen. Darüber hinaus können die Metallschichten der in dem Mehrfachsubstrat enthaltenen Metall-Keramik-Substrate Kontaktbereiche aufweisen, die bevorzugt Silber aufweisen. Die Kontaktbereiche können durch unterschiedliche Techniken ausgebildet sein. Beispielsweise ist es möglich, die Kontaktbereiche durch Abscheidung einer silberhaltigen Schicht vorzusehen. Die Abscheidung der silberhaltigen Schicht erfolgt vorzugsweise chemisch (zum Beispiel elektrochemisch) oder physikalisch.

Bei dem erfindungsgemäßen Verfahren wird in Schritt (b) das Mehrfachsubstrat entlang der Sollbruchlinien des Keramikgrundkörpers unter Vereinzelung der Metall-Keramik-Substrate durchtrennt.

Dabei wird das Mehrfachsubstrat vorzugsweise an verschiedenen Positionen mit Kraft oder Strahlungsenergie beaufschlagt, um ein Durchtrennen entlang der Sollbruchlinien des Keramikgrundkörpers zu bewirken. Durch das Durchtrennen werden die Metall-Keramik-Substrate des Mehrfachsubstrats schließlich vereinzelt. Dabei werden vereinzelte Metall-Keramik-Substrate erhalten.

Das Durchtrennen kann auf unterschiedliche Weisen erfolgen. Gemäß einer bevorzugten Ausführungsform erfolgt das Durchtrennen durch Brechen. Gemäß einer weiteren bevorzugten Ausführungsform erfolgt das Durchtrennen durch Schneiden. Das Schneiden kann zum Beispiel durch Verwendung eines Lasers erfolgen.

In Schritt (c) des erfindungsgemäßen Verfahrens erfolgt eine Auslagerung von vereinzelten Metall-Keramik-Substraten bei einer Temperatur von wenigstens 110°C. In diesem Schritt erfolgt demnach eine Auslagerung von Metall-Keramik-Substraten, die durch Durchtrennen des Mehrfachsubstrats in Schritt (b) vereinzelt wurden. Dabei erfolgt die Auslagerung nicht zwingend von allen vereinzelten Metall-Keramik-Substraten. Von der Erfindung umfasst ist auch eine Auslagerung eines Teils der vereinzelten Metall-Keramik-Substrate. Gemäß einer bevorzugten Ausführungsform erfolgt eine Auslagerung von wenigstens 30%, mehr bevorzugt von wenigstens 50, noch mehr bevorzugt von wenigstens 70%, besonders bevorzugt von wenigstens 80%, ganz besonders bevorzugt von wenigstens 90% und insbesondere von 100% der vereinzelten Metall-Keramik-Substrate.

Die Auslagerung von vereinzelten Metall-Keramik-Substraten erfolgt vorzugsweise bei einer Temperatur von wenigstens 115°C und besonders bevorzugt bei einer Temperatur von wenigstens 120°C. Die Auslagerung von vereinzelten Metall-Keramik-Substraten erfolgt vorzugsweise bei einer Temperatur von nicht mehr als 250°C, besonders bevorzugt bei einer Temperatur von nicht mehr als 210°C und ganz besonders bevorzugt bei einer Temperatur von nicht mehr als 190°C. Die Auslagerung von vereinzelten Metall-Keramik-Substraten erfolgt daher vorzugsweise bei einer Temperatur im Bereich von 110 - 250°C, besonders bevorzugt bei einer Temperatur im Bereich von 115 - 210°C und ganz besonders bevorzugt bei einer Temperatur im Bereich von 120 - 190°C. Die Angabe der Temperatur bezieht sich vorzugsweise auf die Temperatur der Atmosphäre, in der die Auslagerung erfolgt. Die Angabe der Temperatur bezieht sich vorzugsweise auf die maximale Temperatur, bei der die Auslagerung erfolgt.

Gemäß einer bevorzugten Ausführungsform erfolgt die Auslagerung in einem Ofen. Die Temperatur, bei der die Auslagerung von vereinzelten Metall-Keramik-Substrate erfolgt, bezieht sich vorzugsweise auf die Ofentemperatur.

Gemäß einer bevorzugten Ausführungsform erfolgt die Auslagerung von vereinzelten Metall-Keramik-Substraten für einen Zeitraum von wenigstens 1 s, mehr bevorzugt für einen Zeitraum von wenigstens 5 s, besonders bevorzugt für einen Zeitraum von wenigstens 10 s, ganz besonders bevorzugt für einen Zeitraum von wenigstens 20 s und insbesondere für einen Zeitraum von wenigstens 40 s. Gemäß einer weiteren bevorzugten Ausführungsform erfolgt die Auslagerung von vereinzelten Metall-Keramik-Substraten für einen Zeitraum von nicht mehr als 25 min, mehr bevorzugt für einen Zeitraum von nicht mehr als 20 min, besonders bevorzugt für einen Zeitraum von nicht mehr als 15 min, ganz besonders bevorzugt für einen Zeitraum von nicht mehr als 10 min und insbesondere für einen Zeitraum von nicht mehr als 7 min. Gemäß einer weiteren bevorzugten Ausführungsform erfolgt die Auslagerung von vereinzelten Metall-Keramik-Substraten daher für einen Zeitraum im Bereich von 1 s - 25 min, mehr bevorzugt für einen Zeitraum im Bereich von 5 s - 20 min, besonders bevorzugt für einen Zeitraum im Bereich von 10 s - 15 min und ganz besonders bevorzugt für einen Zeitraum im Bereich von 40 s - 7 min. Der Zeitraum für die Auslagerung bezieht sich vorzugsweise auf die Zeit, die die vereinzelten Metall-Keramik-Substrate der Temperatur für die Auslagerung ausgesetzt sind.

Die Auslagerung von vereinzelten Metall-Keramik-Substraten bei einer Temperatur von wenigstens 110°C erfolgt vorzugsweise vor der Bestückung der Metall-Keramik-Substrate mit Bauteilen. Die Metall-Keramik-Substrate sind daher zur Bestückung mit Bauteilen geeignet.

Bauteile sind dabei vorzugsweise Objekte, die für eine nicht lösbare Verbindung, insbesondere eine stoffschlüssige Verbindung, mit der Metallschicht, vorzugsweise der Hauptbegrenzungsfläche der Metallschicht, der Metall-Keramik-Substrate vorgesehen sind. Diese Objekte weisen vorzugsweise eine Höhe von wenigstens 10 µm, mehr bevorzugt eine Höhe von wenigstens 100 µm, besonders bevorzugt eine Höhe von wenigstens 200 µm und ganz besonders bevorzugt eine Höhe von wenigstens 500 µm auf. Diese Objekte weisen vorzugsweise eine Höhe von nicht mehr als 20 mm, mehr bevorzugt eine Höhe von nicht mehr als 10 mm, besonders bevorzugt eine Höhe von nicht mehr als 5 mm und ganz besonders bevorzugt eine Höhe von nicht mehr als 3 mm auf. Unter Bestückung wird vorzugsweise ein Verfahren verstanden, mit dem die Bauteile mit der Metallschicht, vorzugsweise der Hauptbegrenzungsfläche der Metallschicht, der Metall-Keramik-Substrate verbunden werden. Dieses Verfahren umfasst vorzugsweise das Aufbringen eines Verbindungsmittels auf die Metallschicht, das zum Beispiel aus der Gruppe ausgewählt sein kann, die aus Lotmitteln, Sintermitteln und Klebstoffen besteht, das Aufbringen eines Bauteils auf das Verbindungsmittel oder auf die Metallschicht, und die Herstellung der Verbindung, zum Beispiel einer Lotverbindung, einer Sinterverbindung oder einer Klebeverbindung, die zum Beispiel durch Erhöhung der Temperatur oder durch Aushärtung erfolgen kann. Bei den Bauteilen kann es sich zum Beispiel um Halbleiterbauteile (beispielsweise Chips) handeln.

Mit dem hierin beschriebenen Verfahren lassen sich somit Metall-Keramik-Substrate erhalten, die ein einheitliches Durchbiegungsmuster aufweisen. Diese Metall-Keramik-Substrate sind daher für eine Bestückung mit Bauteilen besonders geeignet.

### Ausführungsbeispiele

Die vorliegende Erfindung wird nachstehend durch Ausführungsbeispiele näher beschrieben, die jedoch nicht als einschränkend verstanden werden sollen.

### 1. Herstellung von Metall-Keramik-Substraten

### 1.1 Beispiel 1

Zur Herstellung von Metall-Keramik-Substraten gemäß Beispiel 1 wurde ein Mehrfachsubstrat verwendet, bei dem ein Keramikgrundkörper aus einer Siliziumnitridkeramik mit der Abmessung 177,8 x 139 x 0,32 mm beidseitig mit einer Kupferschicht mit der Abmessung 170 x 132 x 0.3 mm über ein AMB-Verfahren verbunden war. Nach der Reinigung wurde auf beide Kupferschichten des Mehrfachsubstrats mittels eines Hot Roll Laminator eine photosensitive Folie aufgebracht. Die photosensitive Folie wurde jeweils mit 30 mJ/cm2 an den zu maskierenden Bereichen belichtet, um das in der photosensitiven Folie enthaltene Polymer zu härten und eine Ätzmaske zu erhalten. Im Anschluss wurden die unbelichteten Stellen der photosensitiven Folie nasschemisch unter Verwendung einer Natriumcarbonatlösung (Konzentration = 10 g/l) entfernt. Danach wurde das mit der Ätzmaske versehene Mehrfachsubstrat durch Spülen gereinigt. Anschließend wurden die unmaskierten Bereiche der Kupferschichten des Mehrfachsubstrats nasschemisch geätzt. Hierzu wurde das Mehrfachsubstrat in einer Ätzanlage mit einer salzsauren Kupferchloridlösung (Kupferionengehalt = 160 g/l) enthaltend Wasserstoffperoxid besprüht. Das Ätzen erfolgte bei einer Temperatur von 50°C und bei einem Sprühdruck von 2,8 bar. Durch das Ätzen wurde Material aus den unmaskierten Bereichen der Kupferschichten des Mehrfachsubstrats abgetragen. Das Mehrfachsubstrat wurde danach gespült. Sodann wurden unmaskierte Bereiche der in dem Mehrfachsubstrat enthaltenen Verbindungsschicht ebenfalls nasschemisch geätzt. Hierzu wurde das Mehrfachsubstrat wiederum in einer Ätzanlage mit einer Ätzlösung besprüht, die Ammoniumfluorid, Fluorborsäure und Wasserstoffperoxid enthielt. Anschließend wurde das Mehrfachsubstrat gespült und getrocknet. Danach wurde die Ätzmaske in einer Strippanlage mit einer 2,5%igen Natriumhydroxidlösung entfernt.

Sodann wurden in den Keramikgrundkörper des Mehrfachsubstrats mittels eines Lasers Sollbruchlinien eingebracht, die ein Durchtrennen in Metall-Keramik-Substrate gleicher Abmaße erlaubten. Das Durchtrennen des Mehrfachsubstrats unter Vereinzelung der Metall-Keramik-Substrate erfolgte anschließend durch ein Brechen.

Die so vereinzelten Metall-Keramik-Substrate wurden anschließend in einem Umluftofen (UF 30PLUS, Memmert) bei einer Temperatur von 150°C für 20 s ausgelagert.

### 1.2 Beispiele 2 - 6

Die Beispiele 2 - 6 wurden analog zu Beispiel 1 durchgeführt, wobei jedoch die Temperatur und die Zeit für die Auslagerung wie in Tabelle 1 angegeben variiert wurden.

### 1.3 Vergleichsbeispiele 1 - 4

Die Vergleichsbeispiele 1 - 4 wurden analog zu Beispiel 1 durchgeführt, wobei jedoch die Temperatur und die Zeit für die Auslagerung wie in Tabelle 1 angegeben variiert wurden.

### 1.4 Vergleichsbeispiel5

Vergleichsbeispiel 5 wurde analog zu Beispiel 1 durchgeführt, wobei jedoch keine Auslagerung erfolgte.

**Tabelle 1: Auslagerungsbedingungen bei der Herstellung der Metall-Keramik-Substrate der Beispiele 1 - 6 und der Vergleichsbeispiele 1 - 5.**

| | Auslagerung | |
|---|---|---|
| | Temperatur (in °C) | Zeit |
| Beispiel | | |
| 1 | 150 | 20 s |
| 2 | 150 | 5 min |
| 3 | 200 | 20 s |
| 4 | 200 | 5 min |
| 5 | 300 | 20 s |
| 6 | 300 | 5 min |

| Vergleichsbeispiel | | |
|---|---|---|
| 1 | 75 | 20 s |
| 2 | 75 | 5 min |
| 3 | 100 | 20 s |
| 4 | 100 | 5 min |
| 5 | Keine Auslagerung | |

### 2. Auswertung

Die in den Beispielen und Vergleichsbeispielen hergestellten Metall-Keramik-Substrate wurden anschließend untersucht.

### 2.1 Durchbiegungsmuster

Zunächst wurden die Durchbiegungsmuster der ausgelagerten Metall-Keramik-Substrate untersucht. Diese wurde optisch bestimmt und einem von sechs Durchbiegungsmustertypen zugewiesen (Durchbiegungsmuster 1: schüsselartig, Durchbiegungsmuster 2: nach unten verdreht, Durchbiegungsmuster 3: nach oben verdreht, Durchbiegungsmuster 4: X-orientierte Röhre, Durchbiegungsmuster 5: X-orientierter Sattel, Durchbiegungsmuster 6: Y-orientierte Röhre). Der Anteil an vereinzelten Metall-Keramik-Substraten, die sich den verschiedenen Durchbiegungsmustern zuweisen ließen, bezogen auf die Gesamtpopulation der in den jeweiligen Beispielen und Vergleichsbeispielen erhaltenen, vereinzelten Metall-Keramik-Substrate, ist in Tabelle 2 dargestellt.

### 2.2 Lötverhalten

Anschließend wurde die Eignung der ausgelagerten Metall-Keramik-Substrate zum Löten in einem Lötverfahren untersucht. Die vereinzelten Metall-Keramik-Substrate der Beispiele 1 und 2 sowie der Vergleichsbeispiele 1 - 5 konnten unmittelbar nach der Auslagerung verlötet werden. Die Metall-Keramik-Substrate der Beispiele 3 - 6 zeigten eine oberflächliche Oxidation, die vor dem Lötvorgang entfernt wurde. Zum Löten wurden die ausgelagerten Metall-Keramik-Substrate mit jeweils 200 µm dicken Lotvorformen (38 × 27 mm²) einer SnAg3.5-Lotlegierung bestückt, um diese dann mit einem Kühlkörper aus Kupfer mit der Dicke von 3 mm zu verbinden. Das Lötverfahren wurde in einer Vakuum-Lötanlage durchgeführt. Dabei erfolgte eine Aktivierung mittels Ameisensäure in einem Temperaturbereich von 185°C - 200°C bei einer Einwirkzeit von 6 Minuten. Die darauffolgende Lötung erfolgte bei einer Peaktemperatur von 250°C im Vakuum.

### 2.2.1 Untersuchung auf Delamination

Die Lötstellen wurden nach der Lötung mittels Ultraschallmikroskopie (Scanning Acoustic Microscopy) mit dem Gerät AM 300 (PVA TePla Analytical Systems) auf Delamination der Kühlkörper hin untersucht. Hierzu wurden Graustufenbilder der Lötstelle, die mit der Ultraschallmikroskopie erhalten wurden, qualitativ bewertet. Die Ergebnisse sind in Tabelle 2 dargestellt.

### 2.2.2 Untersuchung auf Fehlstellen in der Lötstelle

Ferner wurde das Auftreten von Fehlstellen (zum Beispiel Risse oder Lufteinschlüsse) in den Lötstellen mittels Röntgenstrahlung untersucht. Die Untersuchung erfolgte mit dem Röntgengerät Phoenix (GE) bei einem Röhrenstrom von 100 µA und einer Röhrenspannung von 140 kV. Graustufenbilder der Lötstelle, die in der Röntgenstrahluntersuchung erhalten wurden, wurden qualitativ auf Fehlstellen hin bewertet. Die Ergebnisse sind in Tabelle 2 dargestellt.

**Tabelle 2: Ergebnisse der Untersuchungen der ausgelagerten Metall-Keramik-Substrate der Beispiele 1 - 6 und der Vergleichsbeispiele 1 - 5 zum Durchbiegungsmuster, auf Delamination und auf Fehlstellen in der Lötstelle. Bei der Untersuchung auf Delamination bedeuten: "+": keine ausgeprägte Delamination und "-": ausgeprägte Delamination. Bei der Untersuchung auf Fehlstellen bedeuten: "+": geringe Fehlstellenhäufigkeit und "-": hohe Fehlstellenhäufigkeit.**

| | Durchbiegungsmuster | | | | | | Delamination | Fehlstellen |
|---|---|---|---|---|---|---|---|---|
| | 1 | 2 | 3 | 4 | 5 | 6 | Ausprägung | Häufigkeit |
| Beispiel | | | | | | | | |
| 1 | 94% | 0% | 0% | 6% | 0% | 0% | + | + |
| 2 | 94% | 0% | 0% | 6% | 0% | 0% | + | + |
| 3 | 100% | 0% | 0% | 0% | 0% | 0% | + | + |
| 4 | 100% | 0% | 0% | 0% | 0% | 0% | + | + |
| 5 | 100% | 0% | 0% | 0% | 0% | 0% | + | + |
| 6 | 100% | 0% | 0% | 0% | 0% | 0% | + | + |

| Vergleichsbeispiel | | | | | | | | |
|---|---|---|---|---|---|---|---|---|
| 1 | 24% | 29% | 6% | 18% | 23% | 0% | - | - |
| 2 | 24% | 28% | 6% | 18% | 24% | 0% | - | - |
| 3 | 18% | 22% | 0% | 21% | 39% | 0% | - | - |
| 4 | 17% | 20% | 0% | 22% | 40% | 1% | - | - |
| 5 | 39% | 39% | 6% | 0% | 5% | 11% | - | - |

### 2.3 Bewertung

Es zeigte sich, dass die Metall-Keramik-Substrate der Beispiele 1 - 6 ein (weitgehend) einheitliches Durchbiegungsmuster (hier: Durchbiegungsmuster 1) aufwiesen, während die Metall-Keramik-Substrate der Vergleichsbeispiele 1 - 5 inhomogene Durchbiegungsmuster zeigten. Am stärksten war dieser Effekt bei den Metall-Keramik-Substraten der Beispiele 3 - 6 ausgebildet. Diese mussten jedoch aufgrund des Ausbildens einer oberflächlichen Oxidschicht vor dem Löten gereinigt werden. Die Metall-Keramik-Substrate der Beispiele 1 - 6 erwiesen sich gegenüber den Metall-Keramik-Substraten der Vergleichsbeispiele 1 - 5 überlegen in Bezug auf die Delamination und das Ausbilden von Fehlstellen nach der Anbindung mit einem Bauteil.

## Patentansprüche

1. Verfahren zur Herstellung von Metall-Keramik-Substraten umfassend die Schritte:
(a) Bereitstellen eines Mehrfachsubstrats, das eine Mehrzahl von Metall-Keramik-Substraten umfasst, wobei
(i) die Metall-Keramik-Substrate jeweils
(I) einen Keramikkörper und
(II) wenigstens eine Metallschicht, die flächig mit dem Keramikkörper verbunden ist, umfassen, und
(ii) das Mehrfachsubstrat einen Keramikgrundkörper aufweist, der die Keramikkörper der Metall-Keramik-Substrate umfasst, wobei der Keramikgrundkörper Sollbruchlinien aufweist,
(b) Durchtrennen des Mehrfachsubstrats entlang der Sollbruchlinien des Keramikgrundkörpers unter Vereinzelung der Metall-Keramik-Substrate, und
(c) Auslagerung von vereinzelten Metall-Keramik-Substraten bei einer Temperatur von wenigstens 110°C.

2. Verfahren gemäß Anspruch 1, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

3. Verfahren gemäß Anspruch 1 oder 2, **dadurch gekennzeichnet, dass** die Metallschicht Kupfer umfasst.

4. Verfahren gemäß einem der vorangegangenen Ansprüche, **dadurch gekennzeichnet, dass** die Metallschicht mit dem Keramikkörper flächig durch ein Verfahren verbunden ist, das aus der Gruppe ausgewählt ist, die aus DCB (Direct Copper Bonded)-Verfahren und Hartlotverfahren besteht.

5. Verfahren gemäß einem der vorangegangenen Ansprüche, **dadurch gekennzeichnet, dass** die Metallschicht eine Verbindungsschicht umfasst, mit der der Keramikkörper flächig verbunden ist.

6. Verfahren gemäß Anspruch 5, **dadurch gekennzeichnet, dass** die Verbindungsschicht weniger als 1,0 Gewichtsprozent Silber, bezogen auf das Gesamtgewicht der Verbindungsschicht, aufweist.

7. Verfahren gemäß einem der vorangegangenen Ansprüche, **dadurch gekennzeichnet, dass** die Auslagerung bei einer Temperatur im Bereich von 110 - 250°C erfolgt.

8. Verfahren gemäß einem der vorangegangenen Ansprüche, **dadurch gekennzeichnet, dass** die Auslagerung für einen Zeitraum im Bereich von 1 s - 25 min erfolgt.

9. Metall-Keramik-Substrat erhältlich durch ein Verfahren gemäß einem der Ansprüche 1 - 8.
